Europäisches Patentamt

European Patent Office

Office européen des brevets

(11) Veröffentlichungsnummer: **0 495 352 A2**

## EUROPÄISCHE PATENTANMELDUNG

(21) Anmeldenummer: **92100031.1**

(22) Anmeldetag: **02.01.92**

(51) Int. Cl.5: **G06F 7/68**, G06F 7/62

(30) Priorität: **14.01.91 DE 4100866**

(43) Veröffentlichungstag der Anmeldung:
**22.07.92 Patentblatt 92/30**

(84) Benannte Vertragsstaaten:
**DE FR GB IT**

(71) Anmelder: **SIEMENS AKTIENGESELLSCHAFT
Wittelsbacherplatz 2
W-8000 München 2(DE)**

(72) Erfinder: **Hagedorn, Horst, Dipl.-Astronom
Zweigstrasse 18
W-8038 Gröbenzell(DE)**

(54) **Schaltungsanordnung zur Verbesserung der zeitlichen Auflösung aufeinanderfolgender impulsförmiger Signale.**

(57) Ein erster Zähler (8) mißt die Zeit zwischen zwei Eingangsimpulsen. Dieser Zeitwert wird in einem Register (9) gespeichert. Ein weiterer Zähler (13), der mit n-facher Taktfrequenz des ersten Zählers (8) betrieben wird, zählt solange von dem im Register (9) gespeicherten Wert abwärts bis er den Wert O erreicht und erzeugt dann einen Ausgangsimpuls. Die so erzeugten vervielfachten Impulse werden einem dritten Zähler (18) zugeführt. Eine Anordnung (14, 15, 16, 17) ist vorgesehen, die den zweiten und dritten Zähler (13, 18) mit den Eingangsimpulsen (4) synchronisiert und überzählige Impulse ausfiltert. Eine weitere Anordnung (10, 11, 12) sorgt für die Synchronisierung mit einem gegenüber den Eingangsimpulsen längerem Referenzimpuls.

FIG 1

EP 0 495 352 A2

Die Erfindung betrifft eine Schaltungsanordnung zur Verbesserung der zeitlichen Auflösung aufeinanderfolgender impulsförmiger Signale gemäß dem Oberbegriff des Anspruchs 1.

Eine derartige Schaltungsanordnung ist aus dem Siemens User's Manual, Microcomputer Components, 1990, Seite 8 - 53, 8 - 54 bekannt. Die Anordnung dient dazu, die Auflösung von zeitlich aufeinanderfolgenden Impulsen zu erhöhen, d.h. mehrere Impulse zwischen zwei Impulsen zu erzeugen. Hierzu zeigt die FIG 8.2.31 auf Seite 8 - 53 eine Anordnung mit einem ersten Timer T5, welchem die zeitlich aufeinanderfolgenden impulsförmigen Signale T5UD zugeführt werden und der mit einer ersten Betriebsfrequenz arbeitet. Der Zählerstand des Timers T5 wird einem Register CAPREL zugeführt, welches wiederum mit einem zweiten Timer T6 verbunden ist. Der zweite Timer T6 wird mit einem zweiten Taktsignal betrieben, dessen Frequenz ein n-faches des ersten Taktsignales beträgt. Der erste Timer zählt in Vorwärts- und der zweite Timer T6 in Rückwärtsrichtung. Der Ausgang des Timers T6 ist mit weiteren Timern verbunden.

Der erste Timer T5 zählt die Zeit zwischen zwei zeitlich aufeinanderfolgenden Impulsen. Der ermittelte Wert wird in das Register CAPREL geschrieben und dient dem zweiten Timer T6 als Startwert. Dieser zweite Timer T6 zählt nun mit der n-fachen Frequenz des ersten Timers T5 rückwärts und erzeugt bei einem Nulldurchgang ein Ausgangssignal, das einem dritten Timer zugeführt wird und welches zusätzlich veranlaßt, dem im Register CAPREL stehenden Wert in den Timer T6 als neuen Startwert zu laden. Auf diese Weise erzeugt die Anordnung n Impulse zwischen zwei zeitlich aufeinanderfolgenden Eingangsimpulsen, deren zeitliche Abstände ungefähr gleich groß sind.

Derartige Impulsvervielfacher werden vor allem in der Kfz-Elektronik benutzt, wo z. B. der Drehwinkel einer Kurbelwelle bestimmt werden muß. Hierfür erzeugen die Zähne eines Zahnrades, das auf der Kurbelwelle eingesetzt ist, beim Passieren von einem Sensor Impulse. Die Winkelauflösung dieser Impulse ist dabei meist auf relativ große Werte beschränkt, da die Anzahl der Zähne begrenzt ist. Durch die oben gezeigte Anordnung kann nun die Winkelauflösung stark erhöht werden.

Bei der elektronischen Steuerung von Bezinmotoren müssen in Abhängigkeit von der Kurbelwellenstellung elektrische Digitalsignale für die Zündung, die Benzineinspritzung usw. erzeugt werden. Die Stellung der Kurbelwelle bei der diese Signale erzeugt werden sollen, ändert sich während des Betriebs laufend entsprechend den sich ändernden Betriebsbedingungen.

Um derartige Signale zu erzeugen, ist zunächst eine genaue Winkelmessung für die Stellung der Kurbelwelle gegenüber einer definierten Nullage notwendig. Dafür ist vielfach ein Zahnkranz vorgesehen, der wie oben beschrieben mit der Kurbelwelle fest verbunden ist, und dem an einer Stelle zwei Zähne zum Festlegen der Nullage fehlen.

Bei beschleunigter oder verzögerter Rotation ergeben sich Fehler daraus, daß die Unterteilung eines Zahnintervalls aus der Dauer des vorangegangenen Zahnintervalls abgeleitet wird. Diese Fehler summieren sich über einen Umlauf zu unzulässigen Werten.

Aufgabe der Erfindung ist es daher, eine Anordnung zur Verbesserung der zeitlichen Auflösung aufeinanderfolgender impulsförmiger Signale anzugeben, die es ermöglicht, auch bei beschleunigter bzw. verzögerter Impulsfolge eine korrekte Vervielfachung der zeitlich aufeinanderfolgenden impulsförmigen Signale anzugeben.

Diese Aufgabe wird gelöst durch die kennzeichnenden Merkmale des Anspruchs 1. Vorteilhafte Weiterbildungen sind Kennzeichen der Unteransprüche.

Vorteil der Erfindung ist, daß der oben aufgezeigte Fehler durch eine ständige Synchronisation der dem dritten Zähler zugeführten Impulse mit den Zahnimpulsen auf einen sich während eines Zahnintervalls bildenden unkritischen Fehler beschränkt wird. Die durch die Synchronisation zusätzlich auftretenden Taktimpulse für den dritten Zähler werden außerdem unterdrückt. Ein weiterer Vorteil zeigt eine zusätzliche Anordnung die den dritten Zähler mit der Nullstellung eines Zahnkranzes oder einen gegenüber den normalen Impulsen verlängerten Referenzimpuls synchronisiert.

Die Erfindung wird nachfolgend anhand zweier Figuren näher erläutert. Es zeigen

FIG 1     eine erfindungsgemäße Anordnung,

FIG 2     ein Zeitdiagramm der Eingangsimpulse und der am zweiten Zähler abgreifbaren Ausgangsimpulse der in FIG 1 gezeigten Anordnung bei drei verschiedenen Betriebsbedingungen.

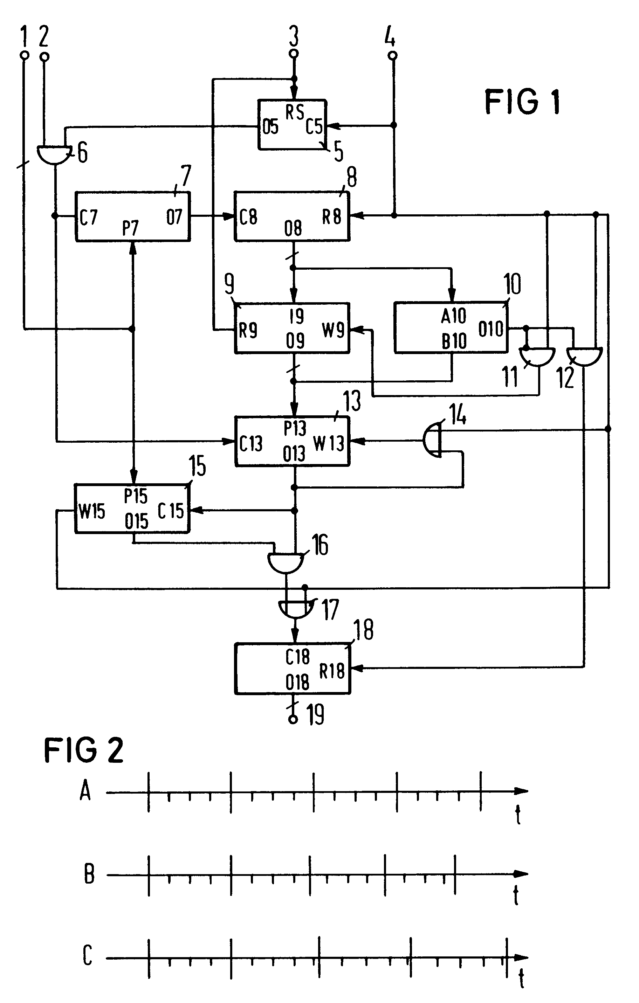

Die in FIG 1 gezeigte erfindungsgemäße Anordnung weist vier Eingänge 1, 2, 3, 4 und einen Ausgang 19 auf. Am Eingang 4 liegen die zeitlich aufeinanderfolgenden impulsförmigen Signale an. Diese führen zum Steuereingang R8 eines ersten Zählers 8. Dieser Zähler 8 wird an seinem Takteingang C8 mit einem ersten Taktsignal betrieben. Der Zählwert der während zwei aufeinanderfolgender Impulse 4 an seinem Steuereingang R8 gemessen wird, liegt am Ausgang O8 an. Dieser führt zu einem Register 9, welches den Wert bei Anliegen eines Steuersignals an seinem Write-Eingang W9 übernimmt. Das Register 9 weist einen Reset-Eingang R9 auf, welcher mit dem Eingang 3 verbunden ist. Der Ausgang O9 des Registers 9 führt zu einem Eingang P13 eines zweiten Zählers 13.

Dieser zweite Zähler 13 ist ein Rückwärtszähler und wird von einem zweiten Taktsignal an seinem Takteingang C13 getaktet. Ein Write-Eingang W13 ist vorgesehen, welcher bei Anliegen eines entsprechenden Signals den Zähler 13 veranlaßt, den an seinem Eingang P13 stehenden Zählerwert als Startwert zu übernehmen. Der Ausgang O13 des Registers 13 ist über einen ersten Eingang eines ODER-Gatter 14 und dessen Ausgang mit dem Write-Eingang W13 verbunden. Desweiteren führt der Ausgang O13 des zweiten Zählers 13 zum ersten Eingang eines UND-Gatters 16. Der Ausgang des UND-Gatters 16 führt zu dem ersten Eingang eines zweiten ODER-Gatters 17, dessen zweiter Eingang mit dem Eingang 4 verbunden ist. Der Ausgang des zweiten ODER-Gatters 17 ist mit dem Takteingang C18 eines dritten Zählers 18 verbunden. Der dritte Zähler 18 weist zusätzlich einen Steuereingang R18 und einen Zählerausgang O18 auf, der mit dem Ausgang 19 verbunden ist. Der dritte Zähler 18 dient als Aufwärtszähler und zählt die Impulse, die an seinem Takteingang C18 anliegen. Über den Steuereingang R18 kann dieser Zähler auf O zurückgesetzt werden. Liegen am Eingang 4 die Ausgangsimpulse eines Winkelgebers an, so liegt am Ausgang des dritten Zählers 18 ein dem Drehwinkel proportionaler Wert an.

Erfindungsgemäß ist ein vierter Zähler 15 vorgesehen. Dieser Zähler 15 ist ein Rückwärtszähler und weist einen Eingang P15, einen Takteingang C15, einen Ausgang O15 und einen Write-Eingang W15 auf. Erreicht der vierte Zähler 15 den Wert O, so wird sein Ausgang O15 auf "L" geschaltet, anderenfalls liegt an seinem Ausgang O15 ein "H"-Signal an. Der Eingang P15 des Zählers 15 ist mit dem Eingang 1 verbunden. Am Takteingang C15 des vierten Zählers 15 liegen die Zählerausgangssignale O13 des zweiten Zählers 13 an. Der Ausgang O15 des vierten Zählers 15 führt zum zweiten Eingang des UND-Gatters 16. Schließlich ist der Writeeingang W15 des vierten Zählers 15 mit dem Eingang 4 verbunden. Der zweite Eingang des ODER-Gatters 14 ist mit der Eingangsklemme 4 verbunden. Der Ausgang des ODER-Gatters 14 führt zum Write-Eingang W13 des zweiten Zählers 13.

Zur Erzeugung der Taktfrequenzen des ersten und zweiten Zählers ist ein fünfter Zähler 7 mit einem Takteingang P7, einem Zählerausgang O7 und einem Zählereingang P7 vorgesehen. Dieser fünfte Zähler 7 dient als Vorteiler für den ersten Zähler 8. Er wird von dem am zweiten Eingang 2 anliegenden Taktsignal gespeist. Der Zählereingang P7 des fünften Zählers 7 ist mit dem ersten Eingang 1 verbunden. Ein zweites UND-Gatter 6 mit zwei Eingängen und einem Ausgang ist vorgesehen. Der erste Eingang des zweiten UND-Gatters 6 ist mit der Eingangsklemme 2 verbunden. Weiterhin ist ein FLip-Flop 5 mit einem Steuereingang P5, einem Ausgang O5 und einem Reset-Eingang R5 vorgesehen. Der Reset-Eingang ist mit der Eingangsklemme 3 verbunden. Der Steuereingang C5 ist mit der Eingangsklemme 4 verschaltet. Der Ausgang O5 des Flip-Flops 5 ist nun mit dem zweiten Eingang des zweiten UND-Gatters 6 verbunden. Die Ausgangssignale des zweiten UND-Gatters 6 werden nun dem Zählereingang C7 des fünften Zählers und dem Takteingang C13 des zweiten Zählers 13 zugeführt.

Erfindungsgemäß ist weiterhin ein Komparator 10 mit zwei Eingängen A10, B10 und einem Ausgang O10 vorgesehen. Der Komparator 10 erzeugt ein "H"-Signal an seinem Ausgang O10, wenn der Wert am Eingang A10 mehr als doppelt so groß als der Wert am Eingang B10 wird. Ansonsten liegt am Ausgang O10 des Komparators ein "L"-Signal. Der erste Eingang A10 des Komparators ist mit dem Ausgang O8 des ersten Zählers 8 und der zweite Eingang B10 des Komparators 10 mit dem Ausgang O9 des Registers 9 verbunden. Ein drittes UND-Gatter 11 mit einem invertierenden und einem nichtinvertierenden Eingang und einem Ausgang sowie ein viertes UND-Gatter 12 mit zwei nichtinvertierenden Eingängen und einem Ausgang sind vorgesehen. Der Ausgang O10 des Komparators führt nun zu dem invertierenden Eingang des dritten UND-Gatters 11 und dem ersten Eingang des vierten UND-Gatters 12. Die jeweils zweiten Eingänge der beiden UND-Gatter 11, 12 sind mit der Eingangsklemme 4 verbunden. Der Ausgang des dritten UND-Gatters 11 ist mit dem Writeeingang W9 des Registers 9 verbunden. Das Ausgangssignal des vierten UND-Gatters 12 führt zum Reset-Eingang R18 des dritten Zählers 18.

Die gezeigte Anordnung ermöglicht es, am Ausgang 19 die Vervielfachung um den Faktor n der am Eingang 4 anliegenden Impulse abzugreifen. Hierzu muß am Eingang 1 der Wert n - 1 digital anliegen. Am Eingang 2 liegt ein Taktsignal z.B. mit einer Frequenz von 5 MHz an. Der Signalzustand am Eingang 3 gibt an, ob die gesamte Anordnung aktiviert oder deaktivert ist. Am Eingang 4 liegen die zeitlich aufeinanderfolgenden impulsförmigen Signale an. Ein Signal am Eingang 3 blokkiert das Flip-Flop 5 und dieses sperrt über das UND-Gatter 6 die Taktimpulse für die Zähler 7 und 13. Dadurch wird auch der Zähler 8 gestoppt. Außerdem setzt es das Register 9 auf den höchsten Wert. Bei einem 16-Bitregister wäre dies z. B. der hexadezimale Wert FFFF. Durch ein entsprechend inverses Signal am Anschluß 3 kippt das Flip-Flop 5 beim nächsten Impuls an der Anschlußklemme 4 um, und gibt synchron zu diesem die Taktimpulse 2 frei. Der nächste Impuls an der Anschlußklemme 4 lädt nun das Register 9 mit einem sinnvollen Wert. Dieser Wert ist proportional zur Zeit zwischen den ersten beiden Impulsen an der Anschlußklemme 4 und wird von dem Zähler 8 ermittelt. Da bis dahin der Inhalt vom ersten Zähler 8 stets kleiner als der Registerinhalt 9 ist, kann das Laden von Register 9 durch das Gatter 11 nicht blockiert werden. Der Komparator 10 und die beiden Gatter 11 und 12 dienen dazu, den dritten Zähler 18 mit dem Nulldurchgang eines Zahnkranzes zu synchronisieren. Zur Bestimmung dieser Nullage eines Zahnkranzes gilt folgendes:

Wie bereits oben näher beschrieben fehlen dem Zahnkranz z. B. eines Drehgebers an der Nullposition zwei Zähne. Dies führt dazu, daß an der entsprechenden Position der erste Zähler 8 bis etwa zum dreifachen Wert der bisherigen Meßwerte zählt. Nun wird der vom ersten Zähler 8 ermittelte Wert mit dem im Register 9 befindlichen Wert, der beim letzten Zahnimpuls vom Zähler 8 übernommen wurde, verglichen. Überschreitet der erste Zähler 8 den doppelten Wert des Inhaltes von Register 9, so wird erstens das Gatter 12 aktiviert, so daß der nächste Impuls an der Anschlußklemme 4 den dritten Zähler 18 auf Null zurücksetzt, und zweitens wird über das Gatter 11 verhindert, daß das Register beim nächstfolgenden Impuls an der Anschlußklemme 4 aus dem ersten Zähler 8 geladen wird, weil der Wert um den Faktor 3 zu groß wäre.

Der erste Zähler 8, das Register 9, der zweite Zähler 13 und der dritte Zähler 18 haben die gleiche Funktion wie in der Einleitung beschrieben. Der zweite Zähler 13 wird gegenüber dem ersten Zähler 8 mit der n-fachen Frequenz betrieben. Die Frequenz des dem ersten Zähler zugeführten Taktsignals wird durch den Zähler 7 um den Faktor n heruntergeteilt. Beispielsweise erhält der zweite Zähler 13 eine Taktfrequenz von ca. 5 MHz. Dieser Wert ist für eine angestrebte Winkelauflösung von ca. 0,3° bei 6000 Umdrehungen/min nötig. Das heißt also, die Zähleinheit vom dritten Zähler 18 soll ca. 0,3° entsprechen. Der Zähler 7 setzt diese Taktfrequenz für den ersten Zähler um den Faktor n herunter. Dieser Wert kann z.B. in einem Speicherregister programmierbar sein und an der Anschlußklemme 1 anliegen. Dieses Register muß hierzu mit dem Wert n - 1 geladen werden.

Die Synchronisation mit den einzelnen Impulsen an der Anschlußklemme 4 erfolgt dadurch, daß jeder Impuls auf den Takteingang des dritten Zählers 18 wirkt. Dies geschieht über das ODER-Gatter 17. Außerdem wird bei jedem Zahnimpuls das Register 9 mit dem soeben aus dem abgelaufenen Impulsintervall vom Zähler 8 neuermittelten Wert geladen. Damit der Ladevorgang des Registers 9 und die Übergabe des neuen Inhaltes des zweiten Zählers 13 ungestört nacheinander erfolgen, muß das Laden des zweiten Zählers 13 etwas verzögert werden. Hierfür notwendige Verzögerer sind der Übersichtlichkeit halber nicht in der FIG 1 enthalten.

Nun sind zwei Fälle zu unterscheiden. Hierzu zeigt FIG 2 den zeitlichen Ablauf von drei Betriebsfällen. Mit t ist in FIG 2 jeweils die Zeitachse gekennzeichnet. Die langen durchgezogenen senkrechten Striche zeigen jeweils die Impulse an der Anschlußklemme 4. Die kurzen Striche stellen die Ausgangssignale des zweiten Zählers 13 dar. Mit A ist die Darstellung der einzelnen Impulse bei konstanter Drehgeschwindigkeit bezeichnet. In diesem Fall treten keinerlei Probleme auf. Die durch die langen senkrechten Striche dargestellten Impulsintervalle werden vom zweiten Zähler 13 in exakt gleich große Teilintervalle unterteilt.

Bei beschleunigter Rotation wie in B dargestellt, ist der n-te Taktimpuls des zweiten Zählers an den dritten Zähler noch nicht erfolgt, wenn der zweite Zähler zurückgesetzt wird. Er entfällt, dafür kommt der synchronisierende Zahnimpuls. Bei gebremster Rotation wie in Teilfigur C dargestellt, kommt der n-te Impuls des zweiten Zählers 13 vor dem Synchronisierungsimpuls. Der dritte Zähler 18 würde einen Taktimpuls zuviel erhalten. Der n-te Impuls des zweiten Zählers muß daher unterdrückt werden. Dies bewirkt die Anordnung, bestehend aus dem Zähler 15 und dem nachgeschalteten Gatter 16. Der vierte Zähler 15 wird jeweils mit dem Wert n - 1 vom Eingang 1 z. B. aus dem obenerwähnten Register geladen und zählt die am Ausgang des zweiten Zählers 13 anliegenden Impulse abwärts. Erreicht der vierte Zähler 15 den Wert O, dann erzeugt er an seinem Ausgang O15 ein Signal, welches das Gatter 16 blockiert. Dadurch wird der n-te Zwischenimpuls ausgefiltert. Da der vierte Zähler 15 weiterzählt, gibt er den nächsten Impuls des zweiten Zählers jedoch wieder frei. Jeder Impuls an der Anschlußklemme 4 setzt den vierten Zähler 15 auf den Wert n - 1.

Auf diese Weise erfolgt eine exakte Synchronisierung mit dem am Anschluß 4 anliegenden Impulsen. Die Fehler, die bei beschleunigter oder gebremster Drehung entstehen, werden so auf ein Minimum reduziert. Der Zählerwert am Ausgang 19 des dritten Zählers 18 ist direkt proportional zum Drehwinkel eines Zahnradgebers.

Alle angegebenen Zählbetriebsarten der Zähler können durch entsprechende Auswertung des Zählerwerts beliebig vertauscht werden. So kann z. B. ein Rückwärtszähler durch einen Vorwärtszähler ersetzt werden, wenn ein 2-er Komplement seines Startwerts gebildet wird.

Die Erfindung ist nicht auf Anordnungen zur Erhöhung der zeitlichen Auflösung impulsförmiger Signale bei Drehwinkelgebern beschränkt.

**Patentansprüche**

1. Schaltungsanordnung zur Verbesserung der zeitlichen Auflösung aufeinanderfolgender impulsförmiger Signale (4) mit
   - einem ersten Zähler (8) mit einem Takteingang (C8), einem Steuereingang (R8) und einem Zählerausgang (08), wobei dem Takteingang (R8) des ersten Zählers (8) ein erstes Taktsignal (O7) und dem Steuereingang (R8) des ersten Zählers die aufeinanderfolgenden impulsförmigen Signale (4) zugeführt werden,
   - einem Register (9), mit Dateneingang (I9), Datenausgang (O9) und Schreib-Eingang (W9), wobei der Dateneingang (I9) des Registers (9) mit dem Zählerausgang des ersten Zählers (8) verbunden ist und dem Schreib-Eingang (W9) die impulsförmigen Signale (4) zugeführt werden,
   - einem zweiten Zähler (13) mit einem Zählereingang (T13), einem Überlaufausgang (O13), einem Takteingang (C13) und einem Schreib-Eingang (W13), wobei der Zählereingang (P13) des zweiten Zählers (13) mit dem Datenausgang (O9) des Registers (9) verbunden ist, wobei dem Schreib-Eingang (W13) des zweiten Zählers (13) seine Überlaufausgangssignale (O13) zugeführt werden und dem Takteingang (C13) des zweiten Zählers (13) ein zweites Taktsignal (2) mit der n-fachen (n > 1) Frequenz des ersten Taktsignals (O7) zugeführt wird,
   **dadurch gekennzeichnet,** daß
   - eine Anordnung vorgesehen ist, die dem Schreib-Eingang (W13) des zweiten Zählers (13) die impulsförmigen Signale (4) als Synchronisationsimpulse zuführt,
   - die Anordnung den n-ten Impuls am Überlaufausgang (O13) des zweiten Zählers (13) ausblendet,
   - die Anordnung ein Ausgangssignal erzeugt, welches aus einer logischen ODER-Verknüpfung des nicht ausgeblendeten Überlaufausgangssignals (O13) und den impulsförmigen Signalen (4) besteht.

2. Schaltungsanordnung nach Anspruch 1,
   **dadurch gekennzeichnet,**
   daß ein dritter Zähler (18) mit einem Takteingang (C18), einem Zählerausgang (O18) und einem Steuereingang (R18) vorgesehen ist, wobei dem Takteingang (C18) das Ausgangssignal der Anordnung zugeführt wird.

3. Schaltungsanordnung nach Anspruch 2,
   **dadurch gekennzeichnet,** daß

   - ein Vergleicher (10) mit zwei Eingängen (A10, B10) und einem Ausgang (O10) vorgesehen ist, der das Zählerausgangssignal (O8) des ersten Zählers (8) mit dem Inhalt des Registers (9) vergleicht und ein logisches "1" Signal an seinem Ausgang (O10) erzeugt, wenn der Zähler (8) den doppelten Wert des Registerinhalts (9) überschreitet und wenn der Zähler (8) ihn unterschreitet oder gleich ist, ein logisches "O" Signal erzeugt,
   - ein erstes Und-Gatter (11) mit einem invertierenden und einem nichtinvertierenden Eingang und einem Ausgang, und ein zweites Und-Gatter (12) mit zwei nichtinvertierenden Eingängen und einem Ausgang vorgesehen ist,
   - der invertierende Eingang des ersten Gatters und der erste Eingang des zweiten Gatters mit dem Ausgang (O10) des Vergleichers (10) verbunden ist,
   - den jeweils zweiten Eingängen der beiden Und-Gatter (11, 12) die impulsförmigen Signale (4) zugeführt werden,
   - der Ausgang des ersten Gatters (11) mit dem Schreib-Eingang (W9) des Registers (9) verbunden ist,
   - der Ausgang des zweiten Gatters (12) mit dem Steuereingang (R18) des dritten Zählers (18) verbunden ist.

4. Schaltungsanordnung nach einem der Ansprüche 1 bis 3,
   **dadurch gekennzeichnet,** daß
   - die Anordnung einen vierten Zähler (15) mit einem Zählereingang (P15), einem Takteingang (C15), einem Zählerausgang (O15) und einem Schreib-Eingang (W15) enthält,
   - der vierte Zähler rückwärts zählt,
   - der Zählerausgang (O15) bei Erreichen des Zählernullstandes ein logisches "O"-Signal und ansonsten ein logisches "1" Signal erzeugt,
   - der vierte Zähler (15) über seinen Zählereingang (P15) bei jedem Impuls der aufeinanderfolgenden impulsförmigen Signale (4) an seinem Schreib-Eingang (W15) mit dem Wert n - 1 (1) vorgeladen wird,
   - der Takteingang (C15) des vierten Zählers (15) mit dem Zählerausgang (O13) des zweiten Zählers (13) verbunden ist,
   - eine Logikgatteranordnung (16, 17) mit drei Eingängen und einem Ausgang vorgesehen ist,
   - dem ersten Eingang die impulsförmigen Signale (4), dem zweiten Eingang die Überlaufausgangssignale (O13) des zweiten Zählers (13) und dem dritten Eingang das Zählerausgangssignal (O15) des vierten Zählers zugeführt wird,

- der Ausgang der Logikgatteranordnung entweder die Impulse der aufeinanderfolgenden impulsförmigen Signale (4) oder bei einer logischen "1" am Zählerausgang (O15) des vierten Zählers (15) die Überlaufausgangssignale (O13) des zweiten Zählers (13) führt.

5. Schaltungsanordnung nach Anspruch 4, **dadurch gekennzeichnet,** daß

- die Logikgatteranordnung aus einem Und-Gatter (16) mit zwei Eingängen und einem Ausgang und einem Oder-Gatter mit zwei Eingängen und einem Ausgang besteht,
- dem ersten Eingang des Und-Gatters das Zählerausgangssignal des vierten Zählers (15) und dem zweiten Eingang des Und-Gatters (16) das Überlaufausgangssignal (O13) des zweiten Zählers (13) zugeführt wird,
- dem ersten Eingang des Oder-Gatters das Ausgangssignal des Und-Gatters und dem zweiten Eingang des Oder-Gatters die aufeinanderfolgenden impulsförmigen Signale (4) zugeführt werden,
- an Ausgang des Oder-Gatters (17) das Ausgangssignal der Anordnung abgegriffen werden kann.

FIG 1

FIG 2